# EUROPEAN PATENT APPLICATION

(11) **EP 4 576 210 A2**
(43) Date of publication of application: **25.06.2025**
(21) Application number: 24213736.2
(22) Date of filing: 18.11.2024
(51) Int. Cl.: H01L 25/065, H01L 25/18

(54) **PACKAGE ARCHITECTURES HAVING VERTICALLY STACKED DIES WITH HIGH CAPACITY MEMORY FOR POWER DELIVERY**

(30) Priority: 18.12.2023 US 202318543089
(71) Applicant: Intel Corporation, Santa Clara, CA 95054 (US)
(72) Inventor: SUTHRAM, Sagar, Portland, 97229 (US); MAHAJAN, Ravindranath Vithal, Chandler, 85248 (US); GOMES, Wilfred, Portland, 97229 (US); HWANG, Jack, Oregon City, 97045 (US); RANADE, Pushkar, San Jose, 95134 (US); SHARMA, Abhishek A., Portland, 97229 (US)
(74) Representative: 2SPL Patentanwälte PartG mbB

(57) **Abstract**

Embodiments of an integrated circuit (IC) package including at least two first IC die having a first surface, an opposing second surface, and including memory circuitry, where the first IC die are stacked and coupled at respective first and second surfaces with a redistribution layer (RDL) between individual ones of the first IC die, the RDL including conductive pathways; a second IC die having a first surface, an opposing second surface, a third surface orthogonal to the first and second surfaces, and a conductive trace parallel to the first and second surfaces, the first surface of the second IC die is electrically coupled to conductive pathways in the RDL; and a third IC die, where the second surface of a bottom die of the stack of first IC die and the third surface of the second IC die are electrically coupled to the third IC die.

## Description

### BACKGROUND

Electronic circuits when commonly fabricated on a wafer of semiconductor material, such as silicon, are called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system, or servers, such as mainframes.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIGS. 1A-1C are schematic cross-sectional views of an example IC die according to some embodiments of the present disclosure.
FIG. 2A is a schematic perspective view of the example IC die of FIG. 1A according to some embodiments of the present disclosure.
FIG. 2B is a schematic perspective view of the example IC die of FIG. 1B according to some embodiments of the present disclosure.
FIG. 2C is a schematic perspective view of the example IC die of FIG. 1C according to some embodiments of the present disclosure.
FIG. 3A is a schematic cross-sectional view of an example microelectronic assembly according to some embodiments of the present disclosure.
FIG. 3B is a schematic cross-sectional view of a portion of the example microelectronic assembly of FIG. 3A.
FIG. 3C is a schematic cross-sectional view of a portion of the example microelectronic assembly of FIG. 3A according to some embodiments of the present disclosure.
FIG. 3D is a schematic cross-sectional view of a portion of the example microelectronic assembly of FIG. 3A according to some embodiments of the present disclosure.
FIG. 3E is a schematic cross-sectional view of an example microelectronic assembly according to some embodiments of the present disclosure.
FIG. 4 is a schematic perspective view of an example microelectronic assembly including the example IC die of FIG. 2A according to some embodiments of the present disclosure.
FIG. 5A is a schematic perspective view of an example IC package according to some embodiments of the present disclosure.
FIG. 5B is a schematic cross-sectional view of an example IC package according to some embodiments of the present disclosure.
FIG. 6A is a schematic perspective view of an example IC package according to some embodiments of the present disclosure.
FIG. 6B is a schematic cross-sectional view of an example IC package according to some embodiments of the present disclosure.
FIG. 6C is a schematic perspective view of an example IC package according to some embodiments of the present disclosure.
FIG. 6D is a schematic cross-sectional view of an example IC package according to some embodiments of the present disclosure.
FIG. 6E is a schematic perspective view of another example IC package according to some embodiments of the present disclosure.
FIG. 7A is a schematic perspective view of an example IC package according to some embodiments of the present disclosure.
FIG. 7B is a schematic cross-sectional view of an example IC package according to some embodiments of the present disclosure.
FIG. 8A is a schematic perspective view of an example IC package according to some embodiments of the present disclosure.
FIG. 8B is a schematic cross-sectional view of an example IC package according to some embodiments of the present disclosure.
FIG. 9 is a cross-sectional view of a device package that includes one or more microelectronic assemblies in accordance with any of the embodiments disclosed herein.
FIG. 10 is a cross-sectional side view of a device assembly that includes one or more microelectronic assemblies in accordance with any of the embodiments disclosed herein.
FIG. 11 is a block diagram of an example computing device that includes one or more microelectronic assemblies in accordance with any of the embodiments disclosed herein.

### DETAILED DESCRIPTION

### Overview

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in any way to limit the broad scope of the present disclosure and its potential applications.

The trend in the computer industry is to utilize multiple processors in large servers, the multiple processors being coupled together in a single package, such as a Multi-Chip Module (MCM). The multiple processors along with other IC dies containing memory circuits (e.g., cache memory circuits, high-bandwidth memory circuits, etc.) are interconnected by high-speed data buses in the package substrate of the MCM, for example, to enable the totality of processors to operate together. However, current technology in such MCMs is inherently limited in its ability to scale to the bandwidth/distance requirements of next generation servers that could have signal speeds greater than 10 GHz and/or data speeds of 3-10 Terabytes per second. The limitations are primarily associated with bandwidth reduction, signal delay, signal loss, and signal distortion due to various reasons, one of which is the configuration in which the multiple processors are coupled together inside the package as well as complicated and low efficiency power delivery networks.

Current packaging architecture, whether 2D, 2.5D or 3D, utilizes multiple IC dies that are oriented parallel to each other and interconnected by various kinds of interconnects, such as copper microbumps, solder balls, etc. In a general sense, any typical IC die consists of a substrate, an active region in the substrate comprising transistors and other active circuitry, and a metallization stack over the substrate, sharing a contact area with the active region. The metallization stack is the region of the IC die in which the individual devices (e.g., transistors, capacitors, resistors, etc.) are interconnected with conductive traces and conductive vias. Common metals used for the conductive traces and conductive vias are copper and aluminum. The metallization stack typically includes contact pads, insulating layers (e.g., interlayer dielectric (ILD) materials such as silicon oxide), conductive layers comprising the conductive traces, and bonding sites for chip-to-chip or chip-to-package connections. Modern IC dies may include more than ten (10) conductive layers in the metallization stack.

Conventionally, various such IC dies may be stacked within a package in various ways: (1) back-to-back, in which the substrate of one IC die is in direct contact with the substrate of another IC die; (2) back-to-front, in which the substrate of one IC die is in direct contact with the metallization stack of the other IC die; and (3) front-to-front, in which the metallization stacks of the two IC dies are in direct contact. In all these configurations, the IC dies are mutually parallel to each other, with the active circuitry disposed in planes parallel to the contacting areas of adjacent IC dies. Such architecture suffers from certain inherent limitations. For example, compute IC dies comprising high-performance compute circuitry that generates a lot of heat have to be placed on the top of any such stack so that heat can be dissipated properly. Such placement limits the number of high-power compute IC dies that can be placed in a package having a limited (or constrained) footprint.

Microelectronic assemblies disclosed herein may include IC dies that are vertically stacked and electrically coupled at a lateral edge (e.g., stacked back-to-back, back-to-front, or front-to-front, and rotated 90 degrees) to a surface of a base IC die. Such vertically stacked IC packages may include memory IC dies, compute IC dies, or both memory and compute IC dies. Various ones of the microelectronic assemblies disclosed herein may include high capacity memory while reducing the complexity and increasing the efficiency of power delivery to the package relative to conventional approaches.

Disclosed herein are IC die having a first surface, a second surface opposite the first surface, and a third surface orthogonal to the first and second surfaces. The IC die may further include a substrate attached to a metallization stack along an interface that is parallel to the first and second surfaces. The substrate may include memory circuitry. The metallization stack of the IC die may include a plurality of layers of conductive traces in a dielectric material, the conductive traces may be parallel to the first and second surfaces and exposed at the third surface. The third surface of the IC die may be coupled to a base die by interconnects, where the interconnects are coupled to the conductive traces exposed on the third surface. In some embodiments, the interconnects may include oxide-oxide bonds and metal-metal bonds, the metal-metal bonds including first bond-pads in the first IC dies and second bond-pads in the base die, where the first bond-pads include portions of the conductive traces exposed on the third surface.

Accordingly, IC packages, related devices and methods, are disclosed herein. In some embodiments, an integrated circuit (IC) package may include a microelectronic assembly, including a plurality of first IC dies including memory circuitry, the plurality of first IC dies having a first surface and a second surface opposite the first surface, wherein the plurality of first IC dies are stacked and electrically coupled at respective first and second surfaces; and a redistribution layer (RDL) between individual ones of the plurality of first IC dies, wherein the RDLs include conductive pathways; a second IC die having a first surface, a second surface opposite the first surface, a third surface orthogonal to the first and second surfaces, and a conductive trace that is parallel to the first and second surfaces and exposed at the third surface, wherein the first surface of the second IC die is electrically coupled to some of the conductive pathways in the RDLs; and a third IC die having a surface, wherein the second surface of an individual first IC die of the plurality of first IC die is electrically coupled to the surface of the third IC die, and wherein the conductive trace exposed at the third surface of the second IC die is electrically coupled to the surface of the third IC die.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiOj, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material comprises interlayer low-k dielectric that is provided within the IC die. Within package substrates, and PCBs such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

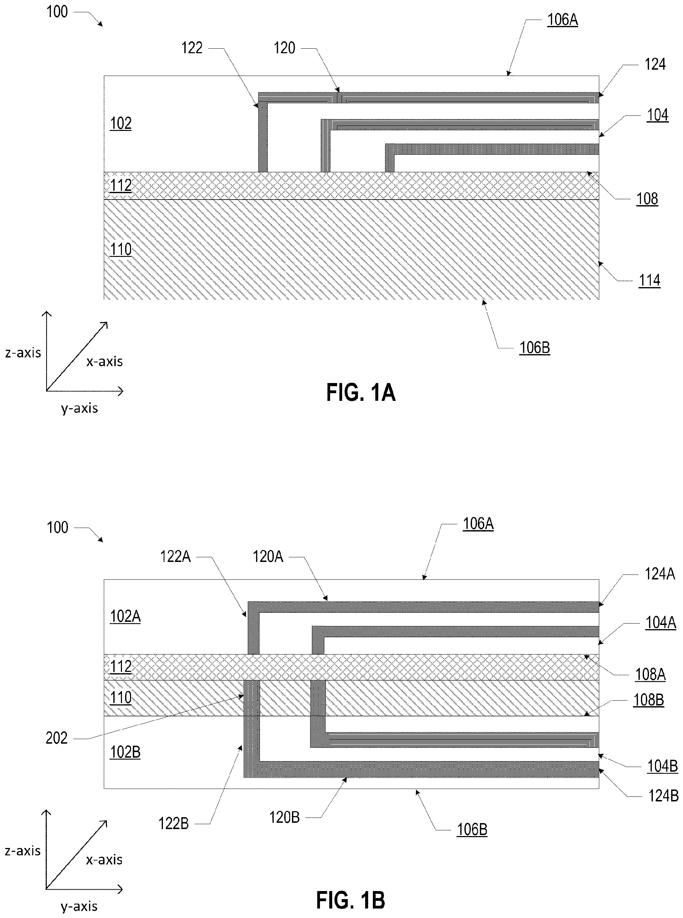

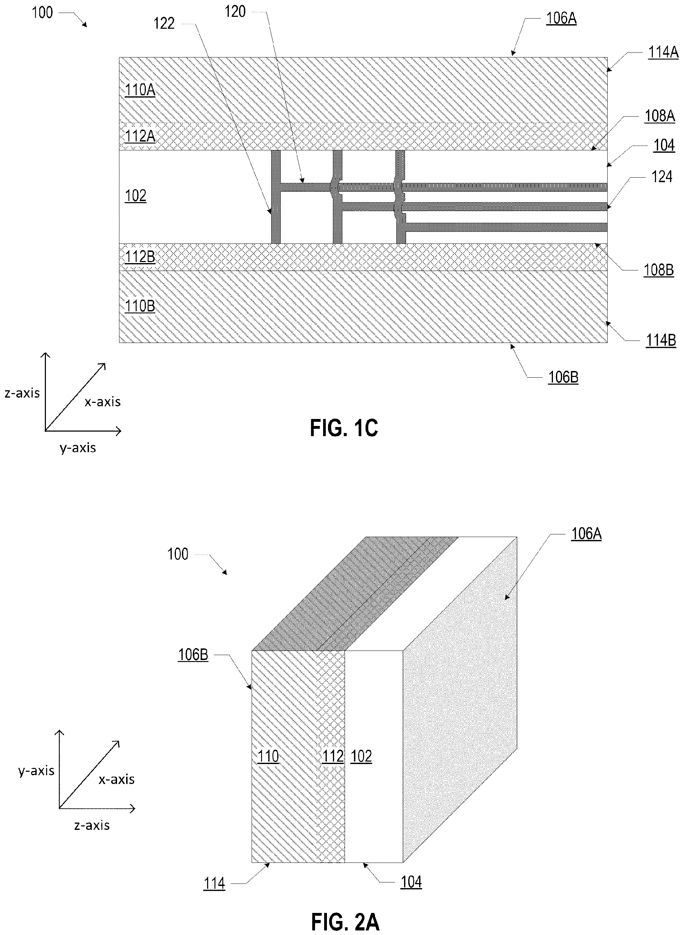

For convenience, if a collection of drawings designated with different letters are present (e.g., FIGS. 1A-1C), such a collection may be referred to herein without the letters (e.g., as "FIG. 1"). Similarly, if a collection of reference numerals designated with different letters are present (e.g., 110A, 110B), such a collection may be referred to herein without the letters (e.g., as "110").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

FIG. 1A is a schematic cross-sectional view of an example IC die 100 according to some embodiments of the present disclosure. IC die 100 includes, in the embodiment shown, a metallization stack 102 having a surface 104 orthogonal to another surfaces 106A, 106B. In various embodiments, surfaces 104 and 106A, 106B may be planarized. Generally, an IC die, that is different from IC die 100, does not have planarized edges along the thickness, e.g., the vertical surfaces corresponding to surface 104 would be rough, having undergone a dicing operation when the IC die is singulated from a wafer. In contrast, surface 104 of IC die 100 may be flat and planar with surface roughness less than 10 Angstroms and total thickness variation (TTV) across surface 104 of less than 3 microns.

Metallization stack 102 may be on a substrate 110 (e.g., at an interface 108). Interface 108 may be orthogonal to surface 104 and parallel to surface 106 (e.g., in the xy-plane). It is to be understood that while the interface 108 is in the xy-plane, the interface 108 may not be exactly planar. The substrate 110 may further include active region 112. In some embodiments, active region 112 may include transistors, diodes, and other active circuitry and may be proximate to interface 108. In some other embodiments, active region 112 may be absent, or alternatively, transistors, diodes, and other active circuitry may be absent in active region 112. In some embodiments, active circuitry may include memory circuitry and/or compute circuitry. Substrate 110 may have a surface 114 that may be coplanar with surface 104. In some embodiments, substrate 110 may include a semiconductor material as listed above in the previous subsection. In other embodiments, substrate 110 may include glass, ceramic, or other materials that may be suitable for creating functional elements of an IC.

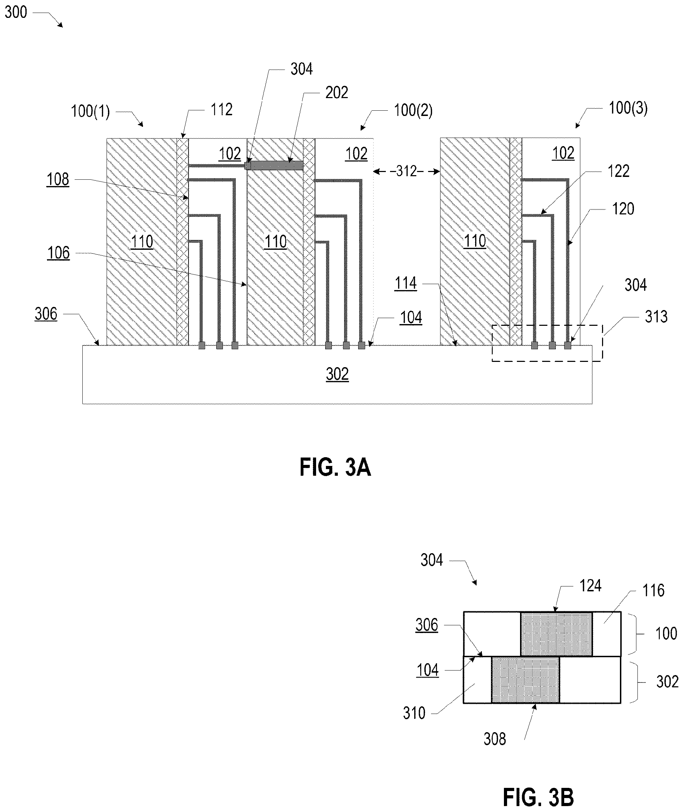

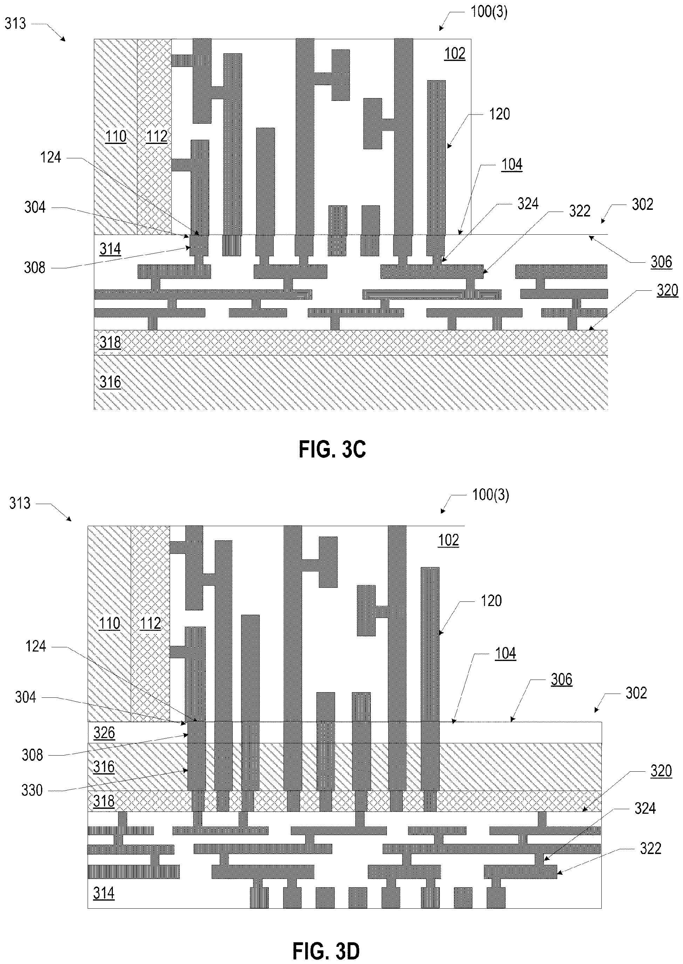

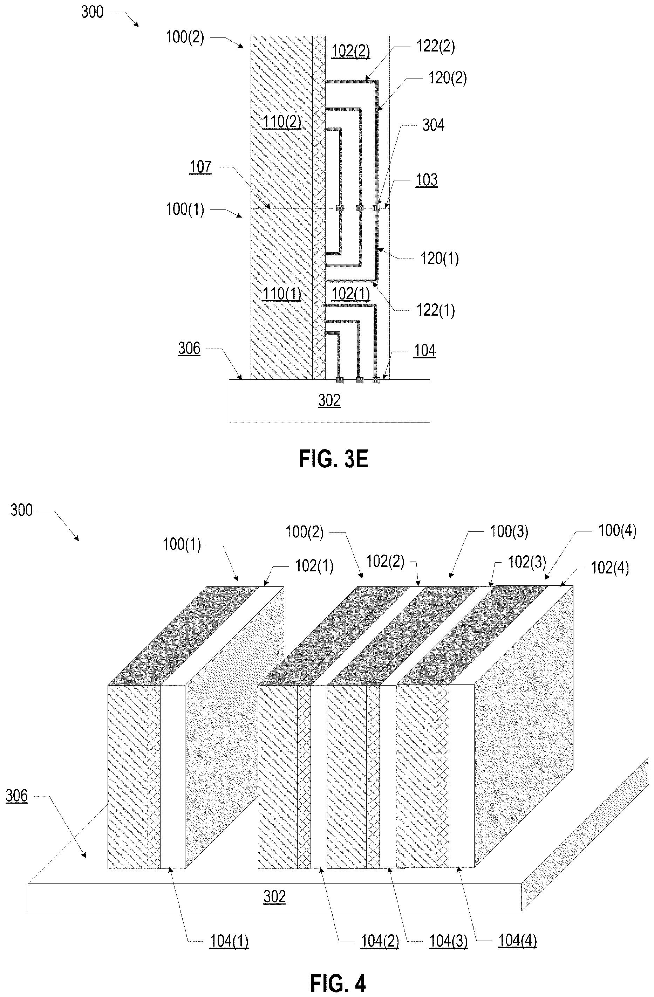

In various embodiments, metallization stack 102 may include a dielectric material, or a plurality of layers of dielectric material, and conductive traces 120 through the dielectric material. The conductive traces 120 may be parallel to surface 106 such that conductive traces 120 are orthogonal to surface 104. In some embodiments, a dielectric material of the metallization stack 102 may include silicon oxide; in other embodiments, the dielectric material of the metallization stack 102 may include any suitable dielectric material used as interlayer dielectrics (ILD) in a typical semiconductor IC die and as described above in the previous subsection. Conductive traces 120 may include a conductive metal, such as copper, in many embodiments. In some embodiments, there may be between 2 and 6 layers of conductive traces 120 in the plurality of layers of dielectric material. Conductive vias 122 through the dielectric material may conductively connect conductive traces 120 to active circuitry in active region 112. Conductive vias 122 are orthogonal to conductive traces 120. Conductive traces 120 may extend up to surface 104 such that portions of conductive traces 120 are exposed on surface 104; such exposed portions may form bonding-portions 124. In various embodiments, there may be several conductive traces 120 between interface 108 and surface 106A. One or more of the conductive traces 120 may be exposed on surface 104 as bonding-portions 124. In some embodiments, a linear dimension (e.g., length, width, or diagonal) of the largest bonding-portion 124 may be less than 5 microns. In some embodiments, bonding-portions 124 may be spaced apart with a pitch of less than 9 microns. In some embodiments, a bond-pad (e.g., similar to conductive bond-pad 308, as shown in FIG. 3) may be formed on a bonding-portion 124 at the surface 104.

FIG. 1B is a schematic cross-sectional view of another example IC die 100 according to some other embodiments of the present disclosure. In some embodiments, IC die 100 may include metallization stacks 102A and 102B on either side of substrate 110. Metallization stack 102A may share interface 108A with substrate 110, and metallization stack 102B may share interface 108B with substrate 110. In some embodiments, as shown in FIG. 1B, active region 112 may be proximate to interface 108A; in other embodiments, active region 112 may be proximate to interface 108B. Conductive traces 120A and conductive vias 122A may be in metallization stack 102A. Conductive traces 120B and conductive vias 122B may be in metallization stack 102B. In some embodiments, conductive traces 120A may be configured to route signals, whereas conductive traces 120B may be configured to route power and ground to active region 112. In such embodiments, conductive traces 120B may be thicker than conductive traces 120A (i.e., conductive traces 120A may be thinner than conductive traces 120B). In other embodiments, conductive traces 120A and conductive traces 120B may be configured to route signals, power, and ground without any differentiation between them. In such embodiments, conductive traces 120A and 120B may be of similar thickness. Through-silicon vias (TSVs) 202 through substrate 110 may enable conductive pathways between conductive traces 120A and 120B and/or active region 112 and conductive traces 120B. In some embodiments, TSVs 202 may be through active region 112 (not shown).

FIG. 1C is a schematic cross-sectional view of yet another example IC die 100 according to some embodiments of the present disclosure. In some embodiments, IC die 100 may include substrates 110A and 110B on either side of metallization stack 102. Substrate 110A may include surface 106A and substrate 110B may include surface 106B. Substrate 110A may share interface 108A with metallization stack 102 and substrate 110B may share interface 108B with metallization stack 102. Substrate 110A may include active region 112A and substrate 110B may include active region 112B. Active regions 112A and 112B may be adjacent to metallization stack 102 at respective interfaces 108A and 108B. Substrates 110A and 110B may have respective surfaces 114A and 114B that may be coplanar with surface 104. Metallization stack 102 may include a dielectric material and conductive traces 120 and conductive vias 122 through the dielectric material. Conductive vias 122 are orthogonal to conductive traces 120. The conductive traces 120 may be parallel to interfaces 108A and 108B such that conductive traces 120 are orthogonal to surface 104. Conductive vias 122 through the dielectric material may conductively connect conductive traces 120 to active circuitry in active regions 112A and 112B. One or more conductive vias 122 may further extend through the active regions 112A and/or 112B (not shown). In some embodiments, conductive traces 120 and conductive vias 122 may be configured to route signals between active regions 112A and 112B. In some embodiments, conductive traces 120 and conductive vias 122 may be configured to route power and ground between active regions 112A and 112B. In such embodiments, conductive traces 120 may be thicker (i.e., similar to conductive traces 120B in FIG. 1B). In some embodiments, conductive traces 120 may have a linear dimension (e.g., x-dimension and z-dimension) between 1 micron and 10 microns. Conductive traces 120 may extend up to surface 104 such that portions of conductive traces 120 are exposed on surface 104; such exposed portions may form bonding-portions 124.

FIG. 2A is a simplified perspective view of an IC die 100. FIG. 2A shows IC die 100 of FIG. 1A that has been rotated 90 degrees so that the surfaces 114 and 104 are positioned at the bottom and the surface 106 is positioned laterally. IC die 100 may include substrate 110, active region 112, and metallization stack 102. IC die 100 may have any suitable dimensions.

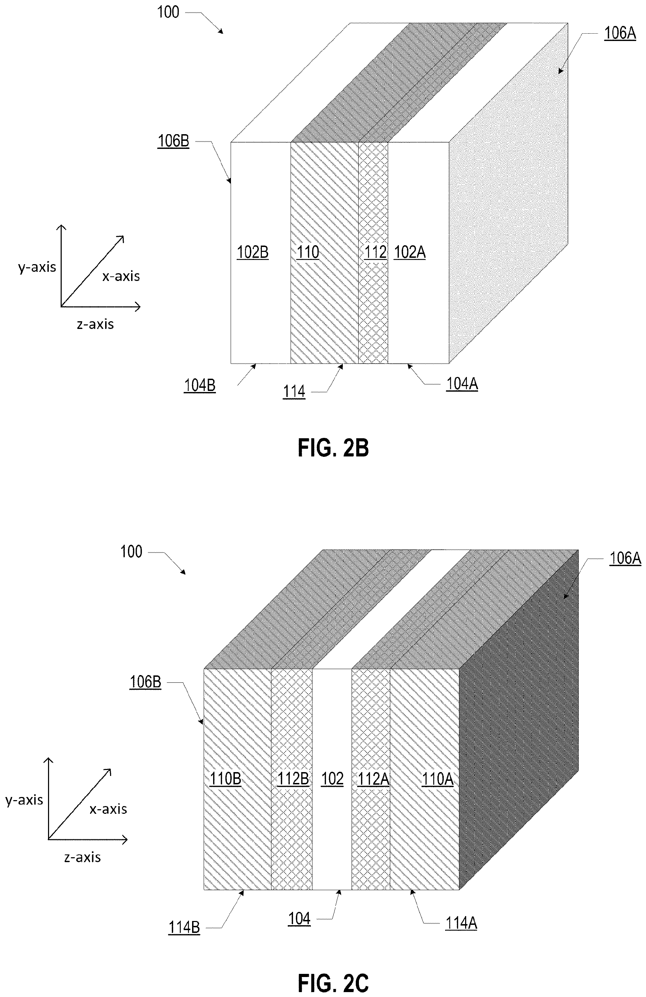

FIG. 2B is a simplified perspective view of an IC die 100. FIG. 2B shows IC die 100 of FIG. 1B that has been rotated 90 degrees so that the surfaces 114, 104A, and 104B are positioned at the bottom and the surfaces 106A, 106B are positioned laterally. IC die 100 may include substrate 110, active region 112, and metallization stacks 102A, 102B. IC die 100 may have any suitable dimensions, including dimensions as described above with reference to FIG. 2A. Substrate 110 may have any suitable thickness (e.g., z-dimension). For example, substrate 110 may have a thickness between less than 1 micron and 50 microns (e.g., between 0.25 microns and 5 microns, or between 20 microns and 50 microns). In some embodiments, substrate 110 may be almost entirely removed such that TSVs 202 may be very thin (e.g., having a thickness of less than 1 micron) and may provide direct contact to a transistor source/drain in active region 112.

FIG. 2C is a simplified perspective view of an IC die 100. FIG. 2C shows IC die 100 of FIG. 1C that has been rotated 90 degrees so that the surfaces 114A, 114B, and 104 are positioned at the bottom and the surfaces 106A, 106B are positioned laterally. IC die 100 may include substrates 110A, 110B, active regions 112A, 112B, and metallization stack 102.

FIGS. 3A-3D show simplified schematic cross-sections of various configurations of a microelectronic assembly 300 according to embodiments of the present disclosure. FIG. 3A shows microelectronic assembly 300 comprising a plurality of IC dies 100, for example, 100(1), 100(2) and 100(3) coupled to another IC die 302 by interconnects 304 such that surface 104 of any one of IC dies 100 is in direct contact with a surface 306 of IC die 302. As described in relation to FIGS. 1 and 2, surface 104 is orthogonal to interface 108 between active region 112 and metallization stack 102 of any one of IC dies 100. In some embodiments, IC dies 100 may include active circuitry (e.g., transistors, diodes) in active region 112. In other embodiments, one or more IC dies 100 may not include active circuitry in active region 112; in such embodiments, active region 112 may be merged with substrate 110 (e.g., absent).

In various embodiments, IC die 302 may include an interposer with conductive traces and/or TSVs to enable conductive coupling of IC die 100 with other IC dies and/or package substrates, and IC die 302 may not have any active circuitry therein. In other embodiments, IC die 302 may include active circuitry. In many embodiments, IC dies 100 may be conductively coupled by conductive pathways in IC die 302. For example, IC die 302 may include a network on chip, interconnecting compute circuitry of IC dies 100 together. In various embodiments, IC die 100 may be conductively coupled to IC die 302 by interconnects 304, which may include hybrid bonds. In such configuration, surface 114 of substrate 110 of IC dies 100 may be in direct contact with surface 306 of IC die 302.

FIG. 3B is a schematic cross-sectional view of a detail of a particular one of interconnects 304 in microelectronic assembly 300. Note that although only interconnect 304 is shown, the same structure and description may apply to any other such interconnects comprising hybrid bonds in microelectronic assembly 300. In a general sense, interconnect 304 may include, at an interface between surface 104 of IC die 100 and surface 306 of IC die 302, metal-metal bonds between bonding-portions 124 of IC die 100 and bond-pads 308 of IC die 302, and dielectric-dielectric bonds (e.g., oxide-oxide bonds) in dielectric materials 116 and 310 of IC dies 100 and 302, respectively. Bonding-portions 124 belonging to IC die 100 may bond with bond-pads 308 of IC die 302. As noted in the description of FIG. 1, bonding-portions 124 may include a portion of conductive traces 120 exposed on surface 104; bond-pads 308 may include conventional conductive structures electroplated on surface 306. Dielectric material 116 (e.g., silicon oxide, silicon nitride, silicon oxynitride, etc.) in IC die 100 may bond with a dielectric material 310 in IC die 302. In some embodiments, dielectric material 310 of IC die 302 is the same as dielectric material 116 of IC die 100. In various embodiments, dielectric material 310 includes silicon oxide, silicon nitride, silicon carbonitride, and other such inorganic materials commonly used to fabricate semiconductor IC dies. The bonded metal and dielectric materials form interconnect 304, comprising hybrid bonds, providing electrical and mechanical coupling between IC die 100 and IC die 302. In various embodiments, interconnects 304 may have a linear dimension of less than 5 microns and a pitch of less than 10 microns between adjacent interconnects.

Turning back to FIG. 3A, IC dies 100 may be coupled to IC die 302 such that metallization stack 102 of one of IC dies 100, for example, 100(1), may be in direct contact with substrate 110 of adjacent IC die 100, for example, 100(2). In such embodiments, IC dies 100(1) and 100(2) may be bonded to each other, at least by oxide-oxide bonds. In some embodiments, interconnects 304, comprising metal-metal bonds and oxide-oxide bonds as described in reference to FIG. 3B, may be present at the planar contact interface (e.g., respective surfaces 106A, 106B, as shown in FIG. 2A) between IC dies 100(1) and 100(2). In some such embodiments, conductive contact between active region 112 of IC die 100(1) and 100(2) may be achieved through conductive traces 120 in IC die 100(1), interconnects 304 at the interface between IC dies 100(1) and 100(2), and TSVs 202 in IC die 100(2); in such embodiments, TSVs 202 are in conductive contact with interconnects 304 between IC dies 100(1) and 100(2). In other embodiments (not shown), metallization stack 102 of IC dies 100(1) and 100(2) may be in contact in a front-to-front configuration. In yet other embodiments (not shown), substrate 110 of IC dies 100(1) and 100(2) may be in contact in a back-to-back configuration.

In various embodiments, IC dies 100 may be arranged in mutually parallel rows such that a gap 312 exists between adjacent IC dies 100. Gap 312 may be uniform across microelectronic assembly 300 in some embodiments and may range approximately in the order of a few millimeters (e.g., less than 5 millimeters); in other embodiments, gap 312 may be non-uniform, with some IC dies 100 being closer to other than other IC dies 100. In some such embodiments, IC dies 100 may include circuitry that consumes electrical power and generates heat during operation. For example, IC dies 100 may include compute circuitry of a microprocessor. Gap 312 may be configured for flow of a cooling fluid therethrough. The cooling fluid (not shown) may be air in some embodiments; in other embodiments, the cooling fluid may be a liquid coolant.

In some embodiments, IC dies 100 may include compute circuitry and VC circuitry, and IC die 302 may include a network on chip circuitry, conductively coupling the array of IC dies 100. In some embodiments, IC dies 100(1), 100(2) may include memory circuitry, IC die 100(3) may include compute circuitry and VC circuitry, and IC die 302 may include a network on chip circuitry, conductively coupling the array of IC dies 100. In some embodiments, IC die 100(1) may include capacitors and/or inductors, IC die 100(2) may include compute circuitry and VC circuitry, IC die 100(3) may include memory circuitry, and IC die 302 may include a network on chip circuitry, conductively coupling the array of IC dies 100. In other embodiments, some IC dies 100 may include graphics processing circuitry and other IC dies may include compute circuitry and VC circuitry, and IC die 302 may include VC circuitry. Any suitable configuration of circuitry may be provided in microelectronic assembly 300 among IC dies 100 and IC die 302 as desired and based on particular needs.

FIG. 3C is a schematic cross-sectional view of a portion 313 of microelectronic assembly 300 of FIG. 3A according to some embodiments of the present disclosure. IC die 302 may include a metallization stack 314 attached to a substrate 316 having an active region 318. Substrate 316 is attached to metallization stack 314 along another interface 320 that is parallel to surface 306. In some embodiments, active region 318 includes active circuitry (not shown), including transistors and diodes. Active region 318 may be proximate to interface 320 in such embodiments. In some embodiments, active region 318 may be absent. Metallization stack 314 may further include conductive pathways (e.g., conductive traces 322 and conductive vias 324) in a dielectric material. In some embodiments, the dielectric material of metallization stack 314 is the dielectric material 310 in FIG. 3B. Conductive traces 322 may be coupled by conductive vias 324 to bond-pads 308.

FIG. 3D is a schematic cross-sectional view of portion 313 of microelectronic assembly 300 of FIG. 3A according to some embodiments of the present disclosure. IC die 302 may be substantially similar to the embodiment of FIG. 3C, except that it is inverted (e.g., turned upside-down), so that substrate 316 is proximate to surface 104 of IC die 100. In such embodiments, IC die 302 may include an interface layer 326 (e.g., bonding layer) on a side of substrate 316 opposite to metallization stack 314. Interface layer 326 includes bond-pads 308 having a dielectric material between bond-pads 308 (e.g., surrounding the bond-pads 308), such that interconnects 304 are formed from metal-metal bonds of bonding-portions 124 and bond-pads 308 and oxide-oxide bonds of dielectric materials of the substrate 110 of IC die 100(3) and of the interface layer 326 of IC die 302. In some embodiments, the dielectric material of the interface layer 326 is a same material as the dielectric material 310 in FIG. 3B. In some embodiments, dielectric material of the interface layer 326 is a same material as the dielectric material 116 of IC die 100 in FIG. 3B. In various embodiments, the dielectric material of the interface layer 326 may include silicon oxide, silicon nitride, silicon carbonitride, or other such inorganic materials commonly used to fabricate semiconductor IC dies. In such embodiments, IC die 302 may further include TSVs 330 in substrate 316 between interface layer 326 and metallization stack 314. TSVs 330 may enable electrical connectivity between interconnects 304 and active region 318 and/or conductive traces 322 in IC die 302.

FIG. 3E is a schematic cross-sectional view of microelectronic assembly 300 according to some embodiments of the present disclosure. The embodiment shown in the figure is similar to that in FIG. 3A, except that IC die 100(1) is coupled end-to-end with IC die 100(2) to form a stack of IC dies. Thus, any single IC die 100 of FIG. 3A is replaced in the embodiment shown in FIG. 3E by corresponding stacks of IC dies 100 coupled end-to-end as described further. IC dies 100(1) and 100(2) may be in direct contact end-to-end along surface 103, opposite to surface 104 of IC die 100(1). Conductive traces 120(1) of IC die 100(1) may be conductively coupled to conductive traces 120(2) of IC die 100(2) through interconnects 304 on surface 103. Substrates 110(1) and 110(2) may be in direct contact on interface 107. In some embodiments, substrates 110(1) and 110(2) may be bonded by oxide-oxide bonds along common interface 107.

FIG. 4 is a simplified perspective view of an example microelectronic assembly 300 including IC dies 100 of FIG. 2A. Note that for ease of illustration, and so as not to clutter the drawings, the figure is not drawn to scale, nor are detailed features shown. A plurality of IC dies 100 (e.g., IC dies 100(1), 100(2), 100(3), and 100(4)) may be coupled at respective surfaces 104 (e.g., surfaces 104(1), 104(2), 104(3), and 104(4)) with surface 306 of IC die 302. The plurality of IC dies 100 may be coupled to IC die 302 by any suitable interconnects, for example, interconnects 304 in FIG. 3. In many embodiments, IC die 302 may be large-sized, for example, as large as a conventional reticle, which can be approximately 858 square millimeters (mm²) in footprint area. Although FIG. 4 shows IC dies 100 having metallization stacks 102(1), 102(2), 102(3), 102(4) facing away from each other, in some embodiments, one or more of IC dies 100 may have one or more metallization stacks 102 facing each other. As shown in FIG. 4, IC dies 100(2), 100(3), and 100(4) may be stacked vertically and bonded together at respective surfaces (e.g., surfaces 106A, 106B, as shown in FIG. 2A), for example, by oxide-oxide bond or inorganic dielectric-inorganic dielectric bonds. The stacked and bonded IC dies 100 may be rotated 90 degrees and electrically coupled at surface 104 to IC die 302. The plurality of IC dies 100 may be coupled to IC die 302 by any suitable interconnects, for example, interconnects 304 in FIG. 3. Stacking and bonding IC dies 100 prior to coupling with IC die 302 may allow for IC dies 100 to be more easily handled during assembly operations. Any suitable number of IC dies 100 may be stacked and bonded together, for example, between 2 and 100 IC dies. Although FIG. 4 shows IC dies 100 having a particular stacked arrangement (e.g., all facing a same direction), in some embodiments, one or more of IC dies 100 may have a different stacked arrangement (e.g., one or more IC dies 100 may be inverted to face an opposite direction). Further, although FIG. 4 includes IC dies 100 of FIG. 1A, a stack of IC dies 100 may include any IC dies 100 of FIGS. 1A-1C.

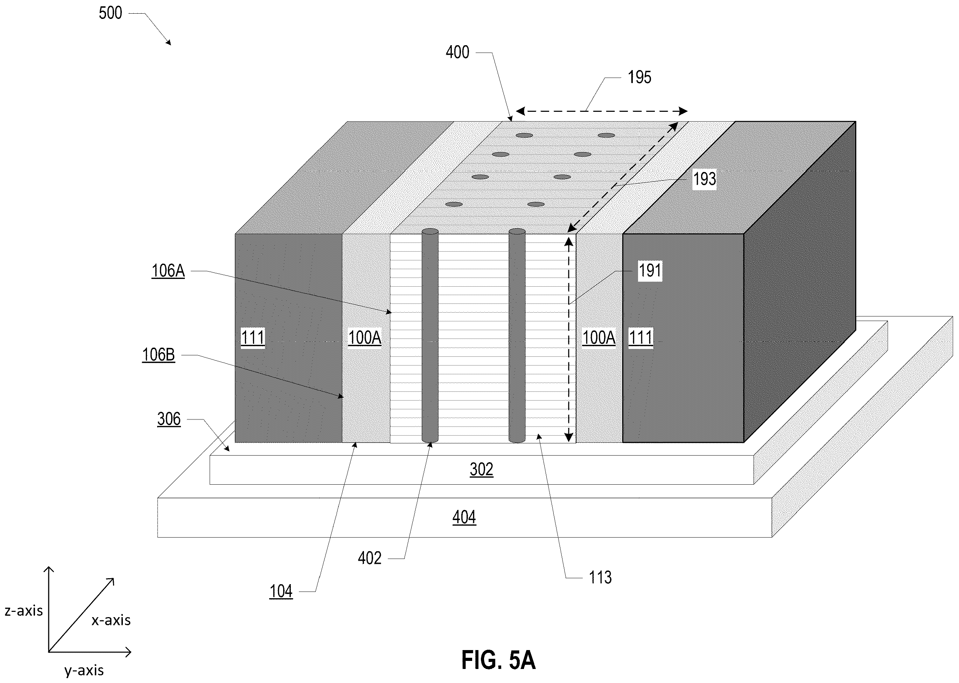

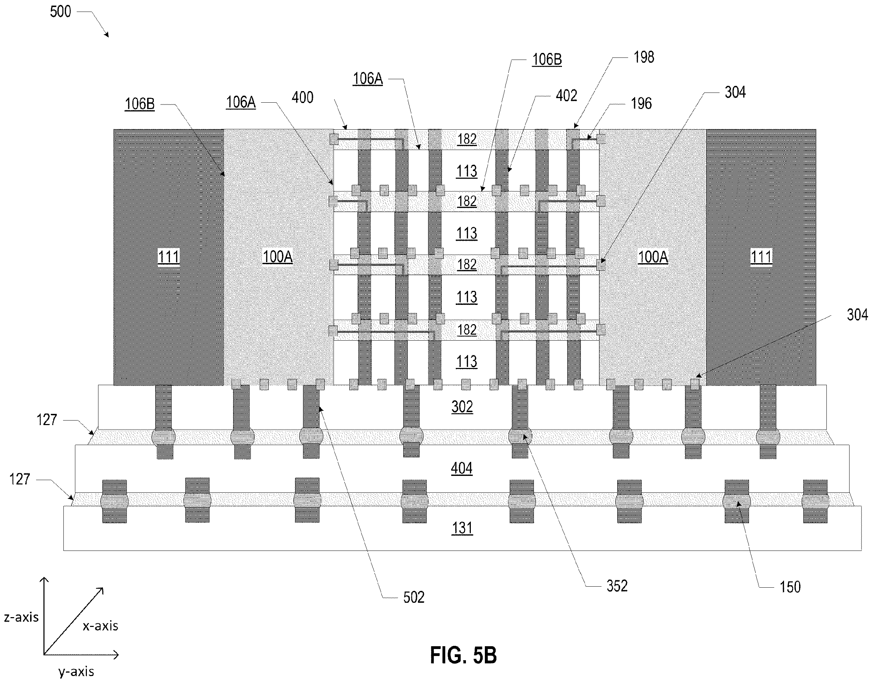

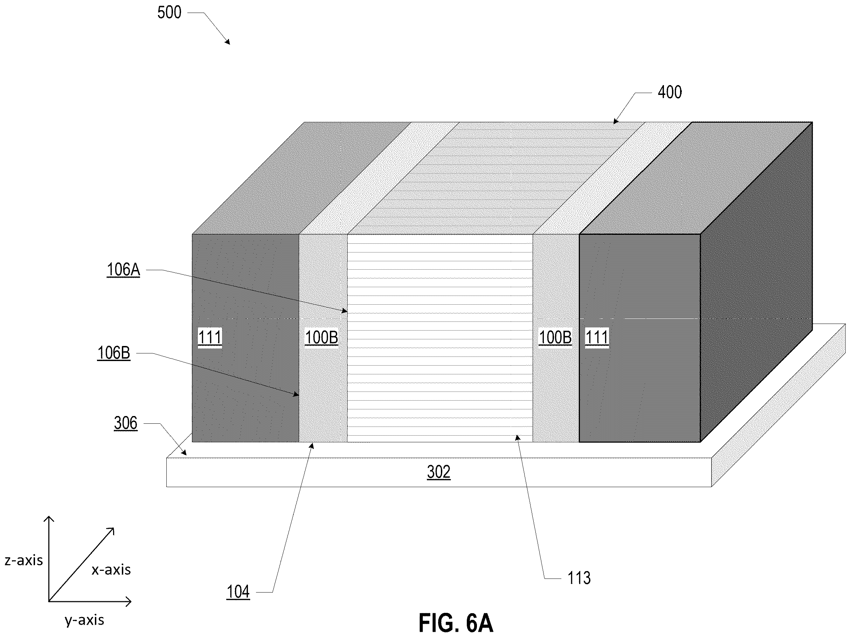

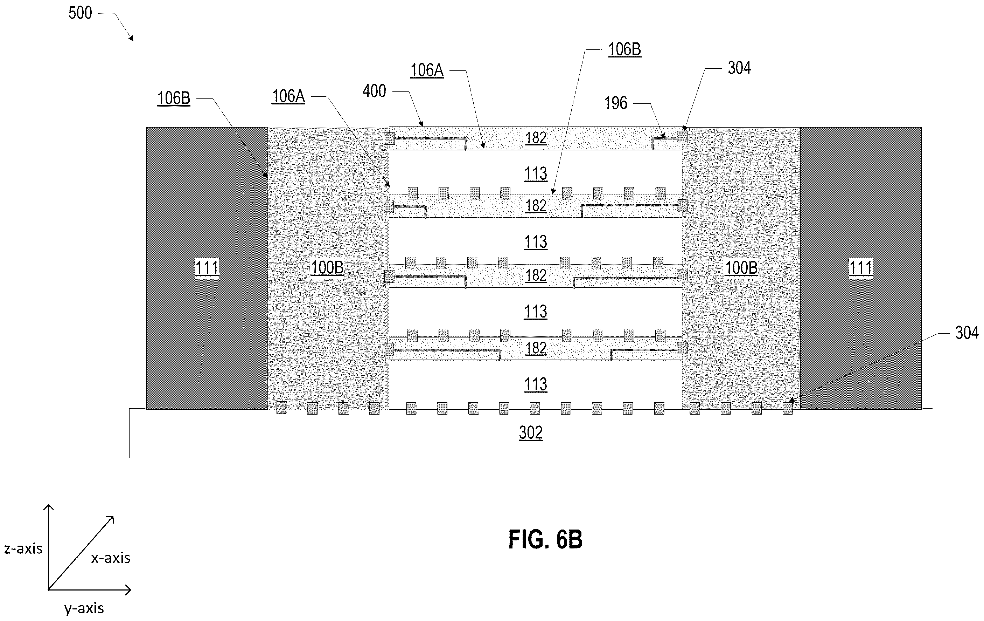

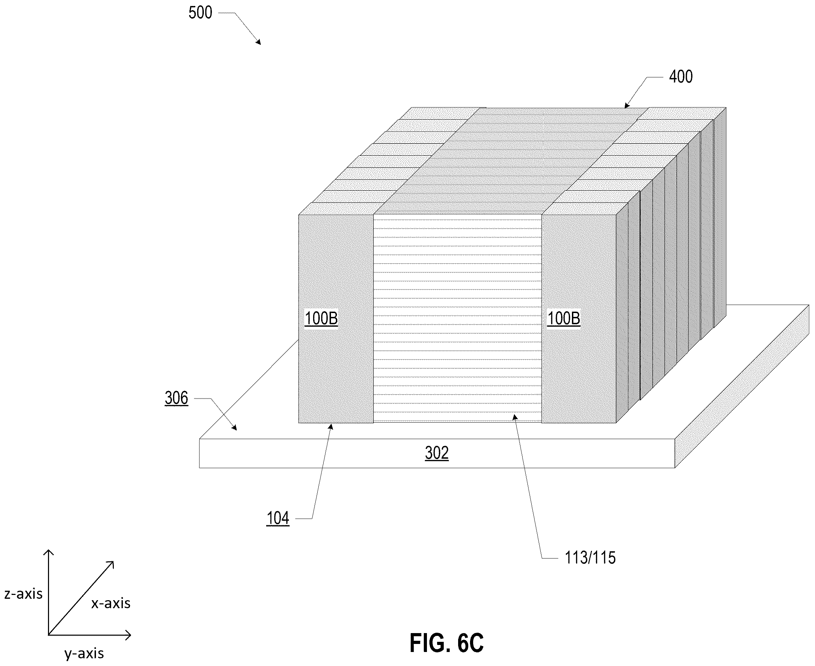

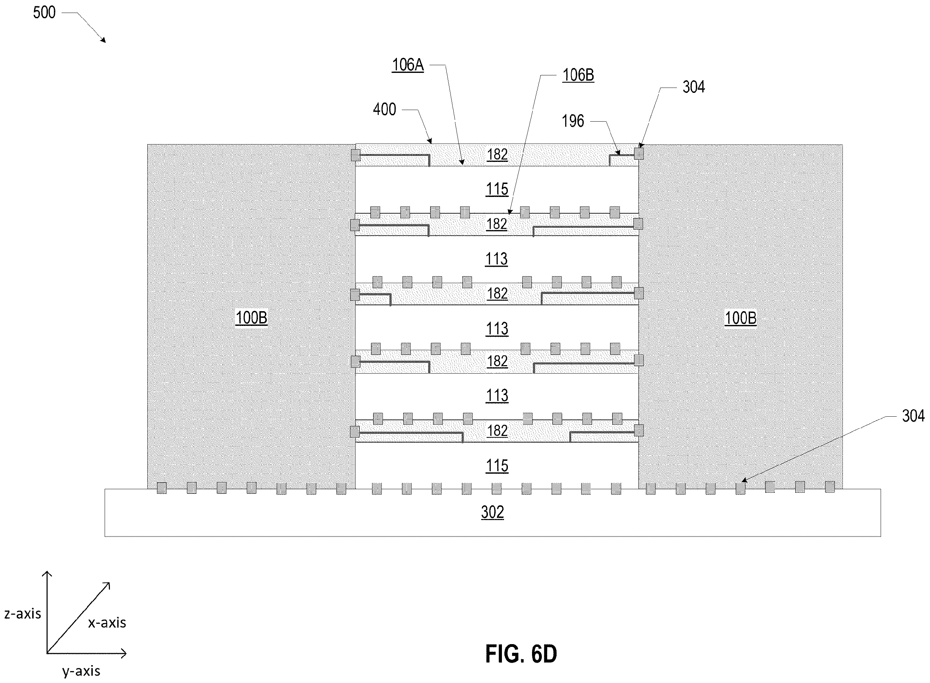

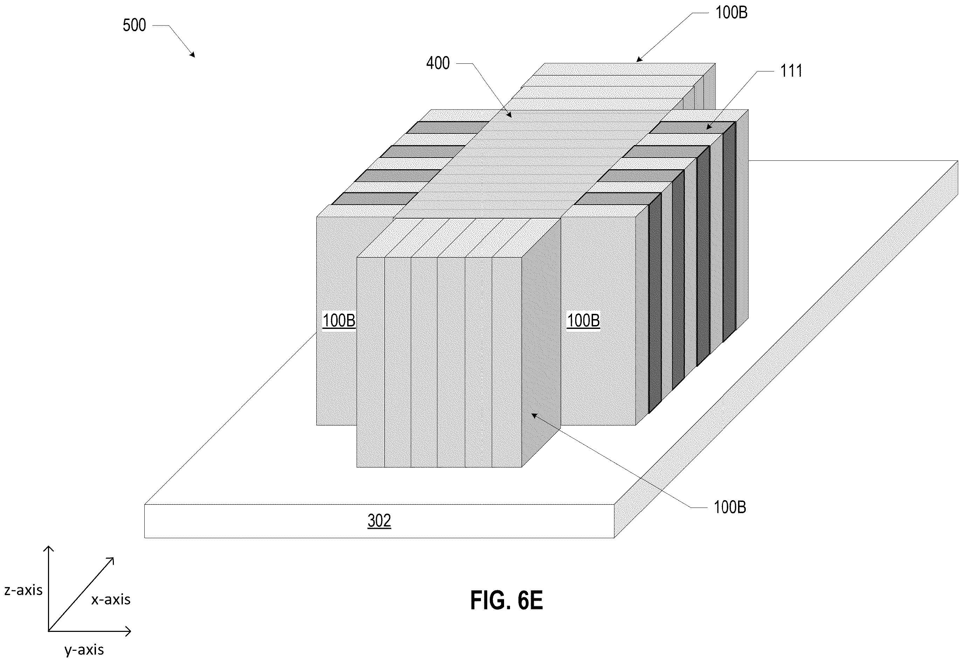

FIG. 5A is a perspective view of IC package 500 according to some embodiments of the present disclosure. The embodiment shown in the figure includes IC die 100A electrically coupled at a lateral surface 104 to a surface 306 of IC die 302 and a microelectronic assembly 400 including a plurality of IC die 113 having TSVs 402 and electrically coupled at respective top and bottom surfaces (e.g., stacked in a conventional pancake-style), and the bottommost IC die 113 is electrically coupled to surface 306 of IC die 302. As used herein, a first surface and an opposing second surface, or a top surface and a bottom surface of IC die 100, 113, 115 (e.g., as shown in FIG. 6) refer to surfaces 106 having a larger surface area, and a lateral surface or an orthogonal surface to first and second surfaces/top and bottom surfaces refer to a side surface (e.g., surface 104 as shown for IC die 100 in FIGS. 1-4). Microelectronic assembly 400 may further include a redistribution layer (RDL) 182 (e.g., as shown in more detail in FIG. 5B) between IC die 113. IC package 500 may further include dummy silicon 111 and a package substrate 404 electrically coupled to IC die 302. Microelectronic assembly 400 may be centrally located on (e.g., in a middle portion of) IC die 302 and IC die 100A may be positioned at opposite sides of microelectronic assembly 400. Dummy silicon 111 may be positioned at the other sides of IC die 100A. In some embodiments, IC die 100A may be positioned at one side of microelectronic assembly 400 or may be positioned at more than two sides of microelectronic assembly 400, for example, at three sides or four sides (not shown) of microelectronic assembly 400. In some embodiments, IC die 100A may include compute circuitry and IC die 113 may include memory circuitry, such as Static Random Access Memory (SRAM) or Dynamic Random Access Memory (DRAM).

IC package 500 of FIG. 5A may provide increased power delivery through memory cube (e.g., microelectronic assembly 400), as compared to conventional IC packages. As used herein, microelectronic assembly 400 also may be referred to as a "memory cube." Microelectronic assembly 400 may have any suitable dimensions. For example, microelectronic assembly 400 may have a height 191 between 3 millimeters (mm) and 5 mm, a width 193 between 10 mm and 20 mm, and a length 195 between 1 mm and 2 mm. Microelectronic assembly 400 may include a between 30 and 40 stacked IC die 113 with TSVs 402, where TSVs 402 are part of a power delivery network. TSVs 402 may have any suitable dimensions for power delivery, for example, TSVs 402 may include between 80 microns and 100 microns of total metal (e.g., copper) to deliver a required amount of current (e.g., approximately 100 amperes) to each IC die 100A. In some embodiments, TSVs 402 may have a diameter between 4 microns and 10 microns.

FIG. 5B is a cross-sectional view of IC package 500 according to some embodiments of the present disclosure. FIG. 5B illustrates IC package 500 of FIG. 5A and further includes a circuit board 131. As shown in FIG. 5B, IC package 500 may include IC die 100A, dummy silicon 111, and microelectronic assembly 400 electrically coupled to a surface 306 of IC die 302 by interconnects 304, IC die 302 may be electrically coupled to package substrate 404 by interconnects 352, and package substrate 404 may be electrically coupled to a circuit board 131 by interconnects 150. Microelectronic assembly 400 may include a plurality of IC die 113 electrically coupled at respective top and bottom surfaces (e.g., surfaces 106A, 106B) with an RDL 182 between adjacent IC die 113. RDL 182 may include conductive pathways 196 and conductive vias 198. Conductive vias 198 may couple with TSVs in individual IC die 113 to form TSVs 402 that extend through microelectronic assembly 400. Conductive pathways 196 enable lateral routing between TSVs 402 and IC die 100A by interconnects 304 at surface 106 of IC die 100A. Conductive vias 198 in RDL 182 are shown as lighter and having dotted lines as compared to TSVs 402 in IC die 113 to allow conductive pathways 196 to be shown more clearly.

An RDL 182 may include an insulating material (e.g., a dielectric material formed in multiple layers, as known in the art) and one or more conductive pathways 196 including conductive vias 198 through the dielectric material, as shown. The conductive vias 198 may be electrically coupled to TSVs 402 to form conductive vias that extend through microelectronic assembly 400. The conductive pathways 196 may electrically couple to the conductive vias 198 for power delivery to IC die 100A. In some embodiments, the insulating material of the RDL 182 may be composed of dielectric materials, bismaleimide triazine (BT) resin, polyimide materials, epoxy materials (e.g., glass reinforced epoxy matrix materials, epoxy build-up films, or the like), mold materials, oxide-based materials (e.g., silicon dioxide or spin on oxide), or low-k and ultra low-k dielectric (e.g., carbon-doped dielectrics, fluorine-doped dielectrics, porous dielectrics, and organic polymeric dielectrics). RDL 182 may have any suitable thickness, for example, in some embodiments, the RDL 182 may have a thickness between 2 microns and 4 microns. RDL 182 may be manufactured using any suitable technique, such as a PCB technique or a redistribution layer technique.

IC die 100A may be selected from one or more of the embodiments shown at least in FIGS. 1A-1C and may include compute circuitry. IC die 100A may be electrically coupled to IC die 302 by conductive traces 120 (e.g., as shown in FIG. 1) and electrically coupled to IC die 113 by conductive pathways 196 in RDL 182. IC die IC die 302, as described above with reference to FIG. 3, may include an interposer with conductive pathways, including TSVs 502, to enable conductive coupling of IC die 100A, 113 with package substrate 404. IC die 113 disclosed herein may include an insulating material (e.g., a dielectric material formed in multiple layers, as known in the art) and multiple conductive pathways formed through the insulating material that electrically couple to conductive contacts on a top surface and/or bottom surface of IC die 113. In some embodiments, the insulating material of IC die 113 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of IC die 113 may include a semiconductor material, such as silicon, germanium, or a III-V material (e.g., gallium nitride), and one or more additional materials. For example, an insulating material may include silicon oxide or silicon nitride. The conductive pathways in IC die 113 may include conductive traces and/or conductive vias, and may connect any of the conductive contacts on IC die 113 (e.g., conductive contacts on a top surface and conductive contacts on a bottom surface) in any suitable manner (e.g., connecting multiple conductive contacts on a same surface or on different surfaces of IC die 113). The conductive pathways in IC die 113 may be bordered by liner materials, such as adhesion liners and/or barrier liners, as suitable. In some embodiments, IC die 113 is a wafer. In some embodiments, IC die 113 is a monolithic silicon, a fan-out or fan-in package die, or a die stack (e.g., wafer stacked, die stacked, or multi-layer die stacked).

The dummy silicon 111 may be coupled to the surface 306 of IC die 302 and to respective surfaces 106 (e.g., surface 106A, 106B, as shown in FIG. 2) of IC die 100A. In accordance with this disclosure, the term "dummy silicon" or "dummy die" refers to a structure that is similar in size and shape to an IC die but that, unlike an IC die, does not have active integrated circuitry. For a non-limiting example, a dummy die may have some features found on IC die such as bond pads but does not contain transistor circuitry that are capable of being powered on or of processing signals. Dummy silicon 111 may include any suitable bulk material. The dummy silicon 111 may include a structurally stiff and thermally conductive material, such as silicon, that may provide mechanical support and stability to IC package 500. In some embodiments, the dummy silicon 111 may be coupled by fusion bonding (i.e., dielectric-dielectric bonds with no metal-metal bonds at the interface). In some embodiments, the dummy silicon 111 may be coupled by diffusion bonding (e.g., metal-metal bonds across the interface, for example, using a surface layer of a soft metal, such as gold or silver, on the bonding surfaces). In some embodiments, the dummy silicon 111 may be coupled by hybrid bonding (e.g., interconnects 304). In some embodiments, the dummy silicon 111 may include a plurality of cavities (e.g., air gaps). In some embodiments, the dummy silicon 111 may include a wafer of silicon cut to fit adjacent to IC die 100A. The dummy silicon 111 may have any suitable dimensions. In some embodiments, the dummy silicon 111, IC die 100A, and microelectronic assembly 400 may have a same overall thickness and width (e.g., z-height 191 and x-dimension 193, as shown in FIG. 5A).

IC package 500 as described herein may further include a package substrate 404. The package substrate 404 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 404 may be a dielectric material, such as an organic dielectric material, a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 404 is formed using standard printed circuit board (PCB) processes, the package substrate 404 may include FR-4, and the conductive pathways in the package substrate 404 may be formed by patterned sheets of copper separated by build-up layers of the FR-4. The conductive pathways in the package substrate 404 may be bordered by liner materials, such as adhesion liners and/or barrier liners, as suitable. In some embodiments, the package substrate 404 may be formed using a lithographically defined via packaging process. In some embodiments, the package substrate 404 may be manufactured using standard organic package manufacturing processes, and thus the package substrate 404 may take the form of an organic package. In some embodiments, the package substrate 404 may be a set of redistribution layers formed on a panel carrier by laminating or spinning on a dielectric material, and creating conductive vias and lines by laser drilling and plating. In some embodiments, the package substrate 404 may be formed on a removable carrier using any suitable technique, such as a redistribution layer technique. Any method known in the art for fabrication of the package substrate 404 may be used, and for the sake of brevity, such methods will not be discussed in further detail herein.

IC die 302 may be coupled to the package substrate 404 by interconnects 352. In some embodiments, the interconnects 352 disclosed herein may have a pitch between about 90 microns and 130 microns. The interconnects 352 disclosed herein may take any suitable form. When interconnects are described herein, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the interconnects. In some embodiments, a set of interconnects 352 may include solder (e.g., solder bumps or balls that are subject to a thermal reflow to form the interconnects 352). The interconnects 352 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 352 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

IC package 500 may further include a circuit board 131. The circuit board 131 may be a motherboard, for example, and may have other components attached to it. The circuit board 131 may include conductive pathways and other conductive contacts for routing power, ground, and signals through the circuit board, as known in the art. The interconnects 150 may be any suitable interconnects, including solder balls for a ball grid array arrangement, pins in a pin grid array arrangement or lands in a land grid array arrangement. In some embodiments, a set of interconnects 150 may include solder (e.g., solder bumps or balls that are subject to a thermal reflow to form the interconnects 150). In some embodiments, the interconnects 150 disclosed herein may have a pitch between about 900 microns and 1.2 mm. In some embodiments, the interconnects 150 may not couple the package substrate 404 to a circuit board 131, but may instead couple the package substrate 404 to another IC package, an interposer, or any other suitable component.

In some embodiments, some of the interconnects in a microelectronic assembly 300 or an IC package 500 as described herein may be metal-to-metal interconnects (e.g., copper-to-copper interconnects, or plated interconnects). In such embodiments, the conductive contacts on either side of the interconnect may be bonded together (e.g., under elevated pressure and/or temperature) without the use of intervening solder or an anisotropic conductive material. In some metal-to-metal interconnects, a dielectric material (e.g., silicon oxide, silicon nitride, silicon carbide) may be present between the metals bonded together (e.g., between copper pads or posts that provide the associated conductive contacts). In some embodiments, one side of an interconnect may include a metal pillar (e.g., a copper pillar), and the other side of the interconnect may include a metal contact (e.g., a copper contact) recessed in a dielectric. In some embodiments, a metal-to-metal interconnect (e.g., a copper-to-copper interconnect) may include a noble metal (e.g., gold) or a metal whose oxides are conductive (e.g., silver). In some embodiments, a metal-to-metal interconnect may include metal nanostructures (e.g., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, a thin cap of solder may be used in a metal-to-metal interconnect to accommodate planarity, and this solder may become an intermetallic compound during processing. In some embodiments, the solder used in some of the interconnects may have a higher melting point than the solder included in other of the interconnects. For example, when the interconnects in an IC package are formed before other interconnects, solder-based interconnects formed first may use a higher-temperature solder (e.g., with a melting point above 200 degrees Celsius), while the interconnects formed second may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth), tin, silver, bismuth, indium, indium and tin, or gallium.

In some embodiments, IC package 500 may also include an underfill material 127. In some embodiments, the underfill material 127 may extend between a bottom surface of IC die 302 and a top surface of the package substrate 404 around the associated interconnects 352 and/or between the bottom surface of the package substrate 404 and the top surface of the circuit board 131 around the associated interconnects 150. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering IC die 302 to the package substrate 404 when forming the interconnects 352 or soldering package substrate 404 to circuit board 131 forming interconnects 150, and then polymerizes and encapsulates the respective interconnects 352, 150. The underfill material 127 may be selected to have a coefficient of thermal expansion (CTE) that may mitigate or minimize the stress between IC die 302 and the package substrate 404 arising from uneven thermal expansion in the IC package 500.

Although FIG. 5 shows a particular number and arrangement of IC die 113 in microelectronic assembly 400, and of IC die 100A, IC die 302, and dummy silicon 111, IC package 500 may include any suitable number and arrangement of microelectronic assembly 400, IC die 100A, IC die 302, and dummy silicon 111. For example, IC package 500 may include four (4) IC die 100A, one at each side of microelectronic assembly 400.

FIG. 6A is a schematic perspective view of another example IC package 500 according to some embodiments of the present disclosure. The embodiment shown in the figure is similar to that of FIG. 5A, except that IC package 500 includes IC die 100B and microelectronic assembly 400 does not include TSVs 402 shown in FIG. 5. IC die 100B may be electrically coupled at a lateral surface 104 to IC die 302. In some embodiments, IC die 302 may include compute circuitry.

FIG. 6B is a cross-sectional view of IC package 500 of FIG. 6A according to some embodiments of the present disclosure. As shown in FIG. 6B, IC package 500 may include a microelectronic assembly 400, IC die 100B, and dummy silicon 111 electrically coupled to surface 306 of IC die 302 by interconnects 304. IC die 100B may be selected from one or more embodiments shown at least in FIGS. 1A-1C and may include active circuitry for transmitting signals at low input voltage (e.g., input voltage between 1 volt (V) and 2V), such as buffer and/or repeater circuitry, or may not include active circuitry (e.g., may include only conductive traces 120 and conductive vias 122, as shown in FIGS. 1-3). Microelectronic assembly 400 having a plurality of IC die 113 electrically coupled at a respective top and bottom surfaces 106A, 106B with RDL 182 in between IC die 113. RDL 182 may include conductive pathways 196 electrically coupling IC die 113 to IC die 100B by interconnects 304 at respective surfaces 106A, 106B of IC die 100B.

FIG. 6C is a schematic perspective view of another example IC package 500 according to some embodiments of the present disclosure. The embodiment shown in the figure is similar to that of FIG. 6A, except that IC package 500 does not include dummy silicon 111 and microelectronic assembly 400 further includes IC die 115. In some embodiments, IC package 500 may further include dummy silicon 111 (not shown).

FIG. 6D is a cross-sectional view of IC package 500 of FIG. 6C according to some embodiments of the present disclosure. As shown in FIG. 6D, IC package 500 may include a microelectronic assembly 400 and a plurality of IC die 100B on opposite sides of microelectronic assembly 400. The plurality of IC die 100B and microelectronic assembly 400 may be electrically coupled to surface 306 of IC die 302 by interconnects 304. The plurality of IC die 100B may be selected from one or more embodiments shown at least in FIGS. 1A-1C and may include active circuitry for transmitting signals at low input voltage (e.g., input voltage between 1 volt (V) and 2V), such as buffer and/or repeater circuitry, or may not include active circuitry. The plurality of IC die 100B may be bonded together at respective surfaces 106A, 106B (e.g., as described above with reference to FIGS. 2-4). Microelectronic assembly 400 may include a plurality of IC die 113 and IC die 115 electrically coupled at a respective top and bottom surfaces 106A, 106B with RDL 182 in between individual IC die 113, 115. RDL 182 may include conductive pathways 196 electrically coupling IC die 113, 115 to IC die 100B by interconnects 304 (e.g., interconnects 304 at the interface along the z-axis between IC die 100B and IC die 113, 115). In some embodiments, IC die 115 is a top IC die and/or a bottom IC die in microelectronic assembly 400, as shown. In some embodiments, IC die 115 may be stacked between IC die 113. Microelectronic assembly 400 may include any suitable number and arrangement of IC die 113, 115, for example, microelectronic assembly 400 may include between 1 and 2 IC die 115 and between 30 and 38 IC die 113.

FIG. 6E is a schematic perspective view of another example IC package 500 according to some embodiments of the present disclosure. The embodiment shown in the figure is similar to that of FIG. 6C, except that IC package 500 further includes dummy silicon 111 between IC die 100B and a plurality of IC die 100B at four sides of microelectronic assembly 400.

Although FIG. 6 shows a particular number and arrangement of IC die 100B and microelectronic assembly 400, IC package 500 may have any suitable number and arrangement of IC die 100B and microelectronic assembly 400, including IC die 113, IC die 115, and dummy silicon 111.

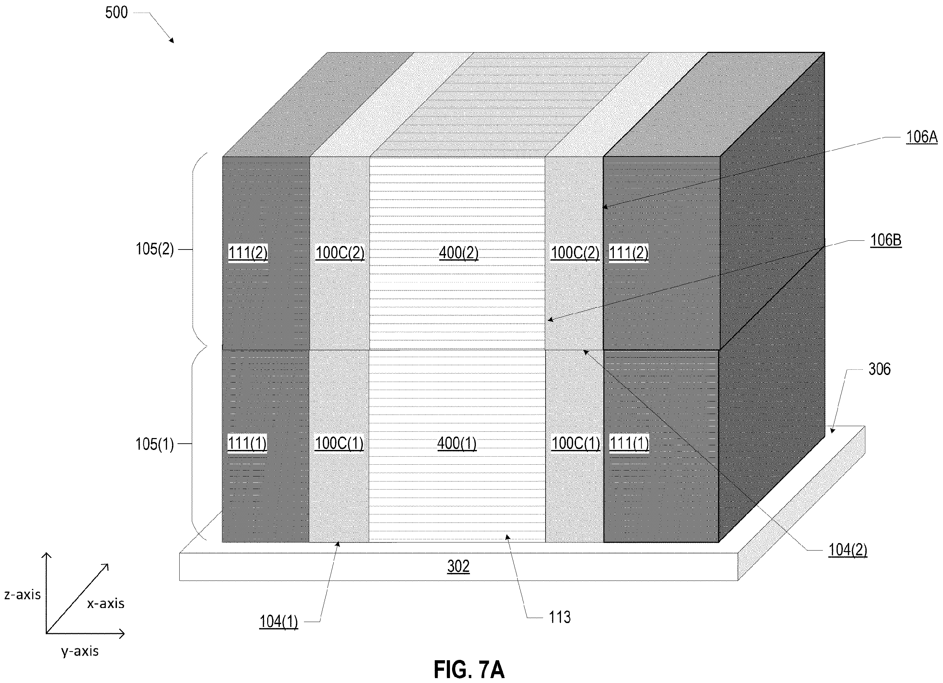

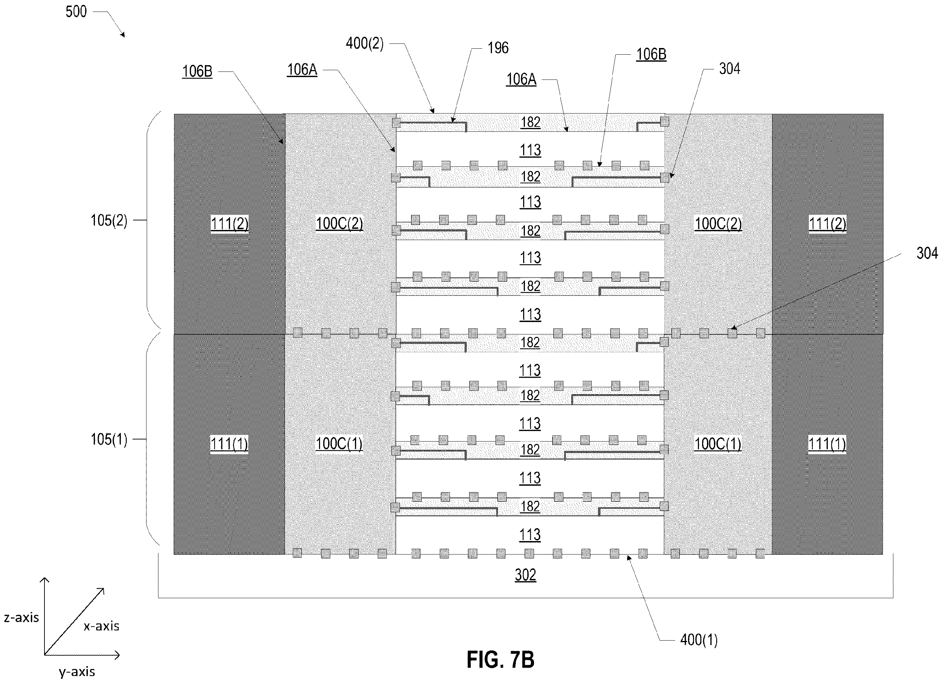

FIG. 7A is a schematic perspective view of another example IC package 500 according to some embodiments of the present disclosure. The embodiment shown in the figure is similar to that of FIG. 6A, except that IC package 500 has multiple layers 105 of stacked microelectronic assembly 400, stacked IC die 100C, and stacked dummy silicon 111. In particular, first layer 105(1) may include microelectronic assembly 400(1), IC die 100C(1), and dummy silicon 111(1) and second layer 105(2) may include microelectronic assembly 400(2), IC die 100C(2), and dummy silicon 111(2), where the second layer 105(2) is on the first layer 105(1). IC die 100C(1) may be electrically coupled at a lateral surface 104(1) to IC die 302. IC die 100C may be selected from one or more of embodiments shown at least in FIGS. 1A-1C, and may include voltage regulator (VR) circuitry. VR circuitry may include electronic components and circuitry for maintaining a constant voltage, for example, a voltage input, a voltage output, an input capacitor, an output capacitor, an inductor, a switching transistor and/or a diode, and a control circuit having a plurality of transistors to perform voltage regulation and to control the switching transistor and/or diode. In various embodiments, VR circuitry may include various voltage rails configured to provide current at correspondingly different voltages. VR circuitry may be fabricated using processes particularly suitable for voltage regulator circuitry, such as a special silicon process, or processes using III-V devices, such as gallium nitride or silicon carbide, for example, to support improved power conversion. IC package 500 of FIG. 7 may provide increased power delivery as compared to conventional IC packages. IC package 500 of FIG. 7 with IC die 100C having VR circuitry enables a high voltage input (e.g., a voltage input of approximately 5V) with reduced current drop along the z-direction (e.g., top to bottom of IC package 500).

FIG. 7B is a cross-sectional view of IC package 500 of FIG. 7A according to some embodiments of the present disclosure. As shown in FIG. 7B, IC package 500 may include a first layer 105(1) having microelectronic assembly 400(1), IC die 100C(1), and dummy silicon 111(1) electrically coupled to surface 306 of IC die 302 by interconnects 304. IC package 500 may further include second layer 105(2) on first layer 105(1) and second layer 105(2) may include microelectronic assembly 400(2), IC die 100C(2), and dummy silicon 111(2). IC die 100C(2) may be stacked on IC die 100C(1) and coupled by interconnects 304 at surface 103 and bonded at interface 107 by oxide-to-oxide bonds, as described above with reference to FIG. 3E. Dummy silicon 111(1) may be bonded to dummy silicon 111(2) using any suitable process, including interconnects 304, as shown, fusion bonding, or diffusion bonding, as described above with reference to FIG. 5. Microelectronic assembly 400 may include a plurality of IC die 113 electrically coupled at a respective top and bottom surfaces 106A, 106B with RDL 182 in between IC die 113. RDL 182 may include conductive pathways 196 electrically coupling IC die 113 to IC die 100C by interconnects 304 at respective surfaces 106A, 106B of IC die 100C. IC die 113 may be electrically coupled to IC die 302 through IC die 100C. Although FIG. 7 shows a particular number and arrangement of microelectronic assembly 400, IC die 100C, and dummy silicon 111, IC package 500 may have any suitable number and arrangement of microelectronic assembly 400, IC die 100C, and dummy silicon 111. Further, although FIG. 7 shows IC package 500 having a particular number of layers, IC package 500 may have any suitable number of layers, including more than two layers.

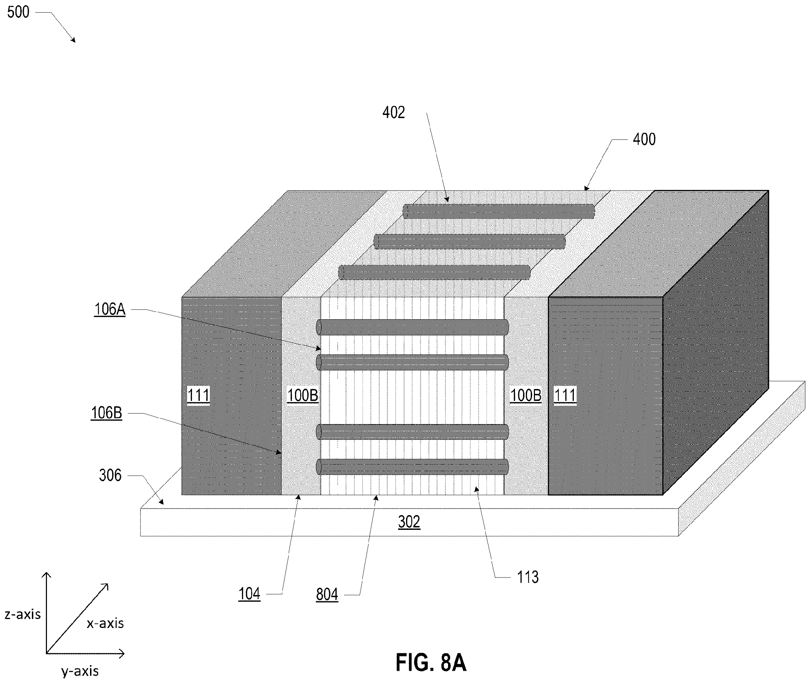

FIG. 8A is a schematic perspective view of another example IC package 500 according to some embodiments of the present disclosure. The embodiment shown in the figure is similar to that of FIG. 5A, except that IC package 500 includes IC die 100B and microelectronic assembly 400 is rotated 90 degrees and electrically coupled at a lateral surface 804 to surface 306 of IC die 302. IC die 100B are electrically coupled at a lateral surface 104 to surface 306 of IC die 302.

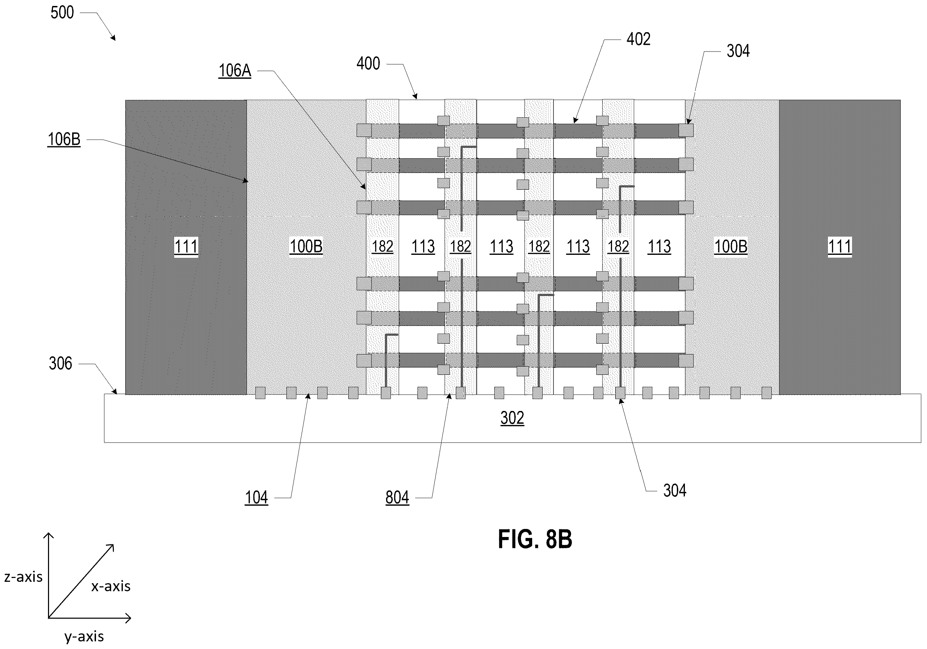

FIG. 8B is a cross-sectional view of IC package 500 of FIG. 8A according to some embodiments of the present disclosure. As shown in FIG. 8B, IC package 500 may include a microelectronic assembly 400 having a plurality of IC die 113 with TSVs 402 that are electrically coupled at respective top and bottom surfaces 106A, 106B (e.g., stacked in a conventional pancake-style) with RDL 182 in between IC die 113, where microelectronic assembly 400 is rotated 90 degrees (e.g., surface 804 is at a bottom and facing towards IC die 302) and surface 804 of microelectronic assembly 400 is electrically coupled to surface 306 of IC die 302. In particular, conductive pathways 196 in RDL 182 are electrically coupled at surface 804 to IC 302 by interconnects 304 and TSVs 402 are coupled to IC die 100B at respective surfaces 106A, 106B by interconnects 304. IC die 100B may be selected from one or more embodiments shown at least in FIGS. 1A-1C and may include active circuitry for delivering power to IC die 113 or may not include active circuitry. Conductive pathways 196 in RDL 182 may be configured to transmit signals and TSVs 402 may be configured to deliver power, such that signal delivery is separate from power delivery. IC package 500 of FIG. 8B may reduce bandwidth crowding issues with power and signaling as compared to conventional IC packages by separating out power delivery and signal transmission.

In various embodiments, any of the features discussed with reference to any of FIGS. 1-8 herein may be combined with any other features to form a package with one or more microelectronic assemblies and one or more IC dies as described herein, for example, to form a modified IC package 500 or a modified microelectronic assembly 400. Some such combinations are described above, but, in various embodiments, further combinations and modifications are possible. Various different embodiments described in different figures may be combined suitably based on particular needs within the broad scope of the embodiments.

### Example devices and components

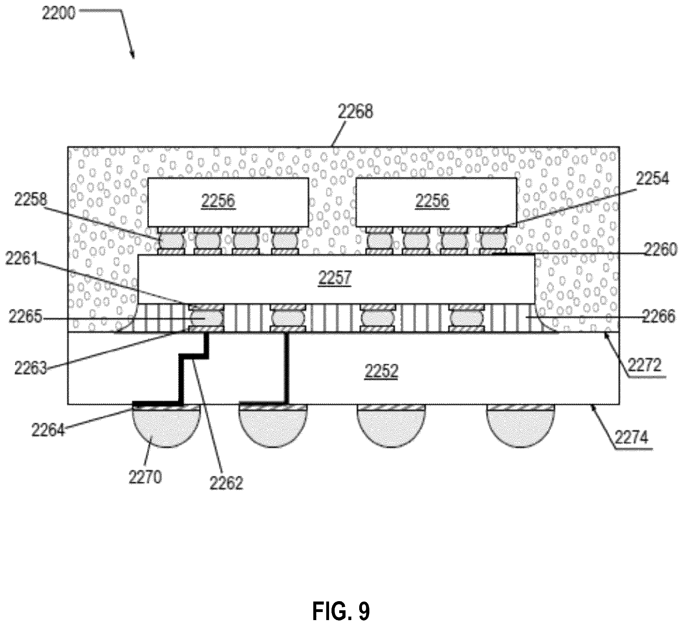

The packages disclosed herein, e.g., any of the embodiments shown in FIGS. 1-8 or any further embodiments described herein, may be included in any suitable electronic component. FIGS. 9-11 illustrate various examples of packages, assemblies, and devices that may be used with or include any of the IC packages as disclosed herein.

FIG. 9 is a side, cross-sectional view of an example IC package 2200 that may include components in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

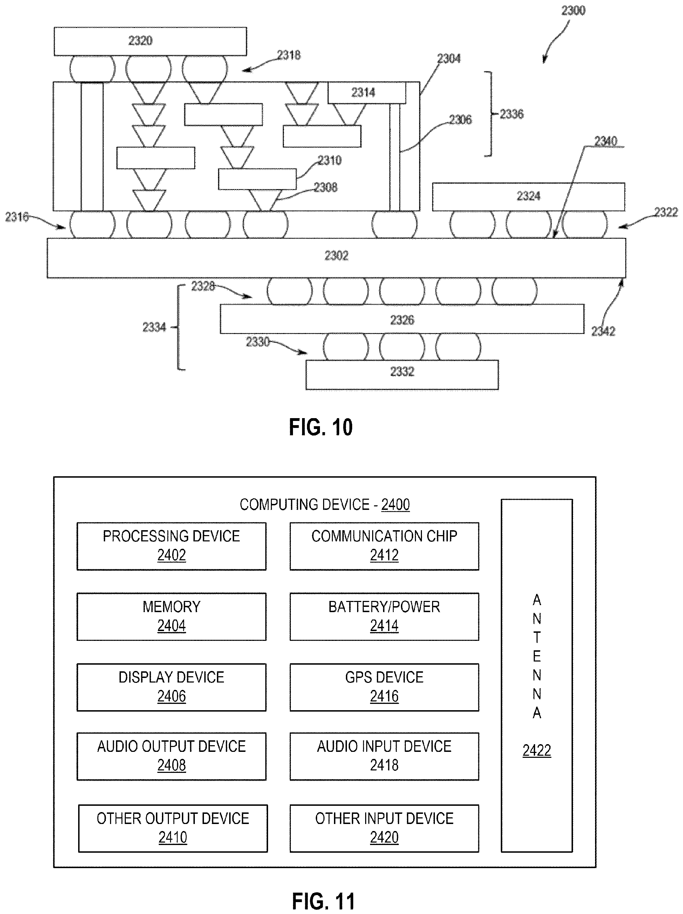

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 10.

In various embodiments, any of dies 2256 may be microelectronic assembly 300 as described herein. In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 300 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 10 is a cross-sectional side view of an IC device assembly 2300 that may include components, in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 300 in accordance with any of the embodiments disclosed herein; e.g., any of the IC packages discussed below with reference to IC device assembly 2300 may take the form of any of the embodiments of IC package 2200 discussed above with reference to FIG. 9.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 9. In some embodiments, IC package 2320 may include at least one microelectronic assembly 300 as described herein. Microelectronic assembly 300 is not specifically shown in the figure in order to not clutter the drawing.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 11 is a block diagram of an example computing device 2400 that may include one or more IC packages or components of IC packages in accordance with any of the embodiments disclosed herein. In another example, any one or more of the components of computing device 2400 may include any embodiments of IC package 2200 (e.g., as shown in FIG. 9). In yet another example, any one or more of the components of computing device 2400 may include an IC device assembly 2300 (e.g., as shown in FIG. 10).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single system-on-chip (SOC) die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

### Select examples

The descriptions of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 is an integrated circuit (IC) package, including a microelectronic assembly, the microelectronic assembly including at least two first IC die including memory circuitry, the at least two first IC die having a first surface and a second surface opposite the first surface, wherein the at least two first IC die are stacked and electrically coupled at respective first and second surfaces; and at least one redistribution layer (RDL) between the at least two first IC die, wherein the RDL includes conductive pathways; a second IC die having a first surface, a second surface opposite the first surface, a third surface orthogonal to the first and second surfaces, and a conductive trace that is parallel to the first and second surfaces and exposed at the third surface, wherein the first surface of the second IC die is electrically coupled to some of the conductive pathways in the at least one RDL; and a third IC die having a surface, wherein the second surface of a bottom die in the stack of the at least two first IC die is electrically coupled to the surface of the third IC die, and wherein the conductive trace exposed at the third surface of the second IC die is electrically coupled to the surface of the third IC die.

Example 2 may include the subject matter of Example 1, and may further include a dummy silicon at the second surface of the second IC die and coupled to the surface of the third IC die.

Example 3 may include the subject matter of Example 1 or 2, and may further specify that the second IC die is one of a plurality of second IC die.

Example 4 may include the subject matter of Example 3, and may further specify that at least one of the at least two first IC die includes compute circuitry.

Example 5 may include the subject matter of Example 3, and may further specify that the plurality of second IC die are bonded together at respective first and second surfaces.

Example 6 may include the subject matter of Example 5, and may further include dummy silicon between individual ones of the plurality of second IC die that are bonded together.

Example 7 may include the subject matter of any of Examples 1-3, and may further specify that the third IC die includes compute circuitry.

Example 8 may include the subject matter of any of Examples 1-3, and may further specify that the microelectronic assembly further includes conductive vias through the at least two first IC die and the RDL, wherein the conductive vias are electrically coupled to the surface of the third IC die.

Example 9 may include the subject matter of any of Examples 1-8, and may further specify that the surface of the third IC die is a first surface and the third further includes a second surface opposite the first surface, and the IC package and may further include a package substrate electrically coupled to the second surface of the third IC die.

Example 10 may include the subject matter of any of Examples 1-9, and may further specify that the first IC die and the second IC die are electrically coupled to the third IC die by metal-metal bonds and dielectric-dielectric bonds.

Example 11 is an integrated circuit (IC) package, including a first layer, the first layer including a plurality of first IC die including memory circuitry, each of the plurality of first IC die having a first surface and a second surface opposite the first surface, wherein the plurality of first IC die are stacked and coupled at respective first and second surfaces with at least one first redistribution layer (RDL) between individual ones of the plurality of first IC die, and wherein the first RDL include first conductive pathways; and a second IC die including voltage regulator circuitry, the second IC die having a first surface, a second surface opposite the first surface, a third surface orthogonal to the first and second surfaces, a fourth surface opposite the third surface, and first conductive traces that are parallel to the first and second surfaces, wherein at least one of the first conductive traces is exposed at the third surface and at least one of the first conductive traces is exposed at the fourth surface, and wherein the first surface of the second IC die is electrically coupled to some of the first conductive pathways in the first RDL; a second layer on the first layer, the second layer including a plurality of third IC die including memory circuitry, each of the plurality of third IC die having a first surface and a second surface opposite the first surface, wherein the plurality of third IC die are stacked and coupled at respective first and second surfaces with at least one second redistribution layer (RDL) between individual ones of the plurality of third IC die, and wherein the second RDL include second conductive pathways; and a fourth IC die including voltage regulator circuitry, the fourth IC die having a first surface, a second surface opposite the first surface, a third surface orthogonal to the first and second surfaces, and a second conductive trace that is parallel to the first and second surfaces and exposed at the third surface, wherein the first surface of the fourth IC die is electrically coupled to some of the second conductive pathways in the second RDL, and wherein the second conductive trace exposed at the third surface of the fourth IC die is electrically coupled to the at least one of the first conductive traces exposed at the fourth surface of the second IC die; and a fifth IC die having a surface, wherein the second surface of the first IC die at a bottom of the plurality of first IC die is electrically coupled to the surface of the fifth IC die, and wherein the at least one of the first conductive traces exposed at the third surface of the second IC die is electrically coupled to the surface of the fifth IC die.

Example 12 may include the subject matter of Example 11, and may further include a first dummy silicon in the first layer at the second surface of the second IC die and coupled to the surface of the fifth IC die; and a second dummy silicon in the second layer at the second surface of the fourth IC die.

Example 13 may include the subject matter of Example 11 or 12, and may further specify that the second IC die is one of a plurality of second IC die and the fourth IC die is one of a plurality of fourth IC die.

Example 14 may include the subject matter of any of Examples 11-13, and may further specify that the second layer is electrically coupled to the first layer by metal-metal bonds and dielectric-dielectric bonds.

Example 15 may include the subject matter of any of Examples 11-14, and may further specify that the plurality of first IC die includes between thirty (30) and forty (40) first IC die.

Example 16 may include the subject matter of any of Examples 11-15, and may further specify that the plurality of third IC die includes between thirty (30) and forty (40) third IC die.

Example 17 is an integrated circuit (IC) package, including a microelectronic assembly, the microelectronic assembly including at least two first IC die including memory circuitry, the at least two first IC die having a first surface, a second surface opposite the first surface, and a third surface orthogonal to the first and second surfaces, wherein the at least two first IC die are stacked and electrically coupled at respective first and second surfaces; at least one redistribution layer (RDL) between individual ones of the at least two first IC die, wherein the RDL includes conductive pathways; and conductive vias orthogonal to the first and second surfaces of the at least two first IC die and extending through the RDL; a second IC die having a first surface, a second surface opposite the first surface, a third surface orthogonal to the first and second surfaces, and a conductive trace that is parallel to the first and second surfaces and exposed at the third surface; and a third IC die having a surface, wherein: the third surfaces of the at least two first IC die in the microelectronic assembly are facing the surface of the third die; the conductive pathways in the RDL are electrically coupled to the surface of the third IC die; the conductive trace exposed at the third surface of the second IC die is electrically coupled to the surface of the third IC die; and the first surface of the second IC die is electrically coupled to some of the conductive vias in the microelectronic assembly.

Example 18 may include the subject matter of Example 17, and may further specify that the conductive pathways in the RDL are configured to transmit signals and the conductive vias are configured to deliver power.

Example 19 may include the subject matter of Example 17 or 18, and may further include a dummy silicon at the second surface of the second IC die and coupled to the surface of the third IC die.

Example 20 may include the subject matter of any of Examples 17-19, and may further specify that the second IC die is one of a plurality of second IC die.

## Claims

1. An integrated circuit (IC) package, comprising:
a microelectronic assembly, comprising:
at least two first IC die including memory circuitry, the at least two first IC die having a first surface and a second surface opposite the first surface, wherein the at least two first IC die are stacked and electrically coupled at respective first and second surfaces; and
at least one redistribution layer (RDL) between the at least two first IC die, wherein the RDL includes conductive pathways;
a second IC die having a first surface, a second surface opposite the first surface, a third surface orthogonal to the first and second surfaces, and a conductive trace that is parallel to the first and second surfaces and exposed at the third surface, wherein the first surface of the second IC die is electrically coupled to some of the conductive pathways in the at least one RDL; and
a third IC die having a surface, wherein the second surface of a bottom die in the stack of the at least two first IC die is electrically coupled to the surface of the third IC die, and wherein the conductive trace exposed at the third surface of the second IC die is electrically coupled to the surface of the third IC die.

2. The IC package of claim 1, further comprising:
a dummy silicon at the second surface of the second IC die and coupled to the surface of the third IC die.

3. The IC package of claim 1 or 2, wherein the second IC die is one of a plurality of second IC die.

4. The IC package of claim 3, wherein at least one of the at least two first IC die includes compute circuitry.

5. The IC package of claim 3 or 4, wherein the plurality of second IC die are bonded together at respective first and second surfaces.

6. The IC package of claim 5, further comprising:
dummy silicon between individual ones of the plurality of second IC die that are bonded together.

7. The IC package of any one of claims 1-6, wherein the third IC die includes compute circuitry.

8. The IC package of any one of claims 1-7, wherein the microelectronic assembly further comprises:
conductive vias through the at least two first IC die and the RDL, wherein the conductive vias are electrically coupled to the surface of the third IC die.

9. The IC package of any one of claims 1-8, wherein the surface of the third IC die is a first surface and the third further includes a second surface opposite the first surface, and the IC package further comprising:
a package substrate electrically coupled to the second surface of the third IC die.

10. The IC package of any one of claims 1-9, wherein the first IC die and the second IC die are electrically coupled to the third IC die by metal-metal bonds and dielectric-dielectric bonds.

11. An integrated circuit (IC) package, comprising:
a first layer, including:
a plurality of first IC die including memory circuitry, each of the plurality of first IC die having a first surface and a second surface opposite the first surface, wherein the plurality of first IC die are stacked and coupled at respective first and second surfaces with at least one first redistribution layer (RDL) between individual ones of the plurality of first IC die, and wherein the first RDL include first conductive pathways; and
a second IC die including voltage regulator circuitry, the second IC die having a first surface, a second surface opposite the first surface, a third surface orthogonal to the first and second surfaces, a fourth surface opposite the third surface, and first conductive traces that are parallel to the first and second surfaces, wherein at least one of the first conductive traces is exposed at the third surface and at least one of the first conductive traces is exposed at the fourth surface, and wherein the first surface of the second IC die is electrically coupled to some of the first conductive pathways in the first RDL;
a second layer on the first layer, the second layer including:
a plurality of third IC die including memory circuitry, each of the plurality of third IC die having a first surface and a second surface opposite the first surface, wherein the plurality of third IC die are stacked and coupled at respective first and second surfaces with at least one second redistribution layer (RDL) between individual ones of the plurality of third IC die, and wherein the second RDL include second conductive pathways; and
a fourth IC die including voltage regulator circuitry, the fourth IC die having a first surface, a second surface opposite the first surface, a third surface orthogonal to the first and second surfaces, and a second conductive trace that is parallel to the first and second surfaces and exposed at the third surface, wherein the first surface of the fourth IC die is electrically coupled to some of the second conductive pathways in the second RDL, and wherein the second conductive trace exposed at the third surface of the fourth IC die is electrically coupled to the at least one of the first conductive traces exposed at the fourth surface of the second IC die; and
a fifth IC die having a surface, wherein the second surface of the first IC die at a bottom of the plurality of first IC die is electrically coupled to the surface of the fifth IC die, and wherein the at least one of the first conductive traces exposed at the third surface of the second IC die is electrically coupled to the surface of the fifth IC die.

12. The IC package of claim 11, further comprising:
a first dummy silicon in the first layer at the second surface of the second IC die and coupled to the surface of the fifth IC die; and
a second dummy silicon in the second layer at the second surface of the fourth IC die.

13. The IC package of claim 11 or 12, wherein the second IC die is one of a plurality of second IC die and the fourth IC die is one of a plurality of fourth IC die.

14. The IC package of any one of claims 11-13, wherein the second layer is electrically coupled to the first layer by metal-metal bonds and dielectric-dielectric bonds.

15. The IC package of any one of claims 11-14, wherein the plurality of first IC die includes between thirty (30) and forty (40) first IC die and the plurality of third IC die includes between thirty (30) and forty (40) third IC die.
